# EUROPÄISCHE PATENTSCHRIFT

(11) **EP 1 404 207 B1**
(45) Veröffentlichungstag und Bekanntmachung des Hinweises auf die Patenterteilung: **06.01.2010**
(21) Anmeldenummer: 02730293.4
(22) Anmeldetag: 12.06.2002
(51) Int. Cl.: A47L 15/00, D06F 1/00, G01R 31/28

(54) **VERFAHREN ZUR ÜBERPRÜFUNG DER ELEKTRISCHEN SICHERHEIT EINES HAUSHALTSGERÄTS UND ENTSPRECHENDES HAUSHALTGERÄT**
METHOD FOR CHECKING ELECTRICAL SAFETY OF A HOUSEHOLD APPLIANCE AND CORRESPONDING HOUSEHOLD APPLIANCE
PROCEDE DE VERIFICATION DE LA SECURITE ELECTRIQUE D'UN APPAREIL MENAGER ET APPAREIL MENAGER CORRESPONDANT

(30) Priorität: 26.06.2001 DE 10130606
(43) Veröffentlichungstag der Anmeldung: 07.04.2004
(73) Patentinhaber: BSH Bosch und Siemens Hausgeräte GmbH, 81739 München (DE)
(72) Erfinder: ROTHAUSZKY, Christian, 89441 Medlingen (DE); ROSENBAUER, Michael, 86756 Reimlingen (DE); REITER, Bruno, 73450 Neresheim-Kösingen (DE); HERING, Reinhard, 89438 Holzheim (DE)
(86) Internationale Anmeldenummer: PCT/EP2002/006460
(87) Internationale Veröffentlichungsnummer: WO 2003/001963

(56) Entgegenhaltungen:
- EP-A- 0 838 192
- DE-A- 2 735 807
- DE-A- 19 940 988
- GB-A- 2 283 870

## Beschreibung

Die Erfindung betrifft ein Verfahren zur Überprüfung der elektrischen Sicherheit eines Haushaltgeräts, das mehrere elektrische Komponenten als Stromverbraucher aufweist, sowie ein entsprechendes Haushaltgerät.

Haushaltgeräte - beispielsweise Geschirrspülmaschinen -, die bekanntlich mehrere Stromverbraucher wie Pumpen, Heizungen etc. aufweisen, unterliegen einer individuellen Überprüfung ihrer elektrischen Sicherheit üblicherweise nicht. Es ist die elektrische Sicherheit lediglich über die bekanntlich im Haushalt, in dem das Haushaltgerät angeordnet ist, vorhandenen Fehlerstromschutzschalter gewährleistet. Dies reicht aber für die Überwachung des einzelnen Haushaltgeräts in den meisten Fällen nicht aus, da über die bekannten Fehlerstromschutzschalter normalerweise Stromkreise mit mehreren Steckdosen abgesichert werden. Daher sind diese Fehlerstromschutzschalter auf einen größeren Stromverbrauch eingestellt und zu träge in der Reaktion auf gerätebezogene Problemfälle. Ein derartiger Problemfall entsteht insbesondere durch Kriechströme, die zwischen stromführenden Teilen und dem Schutzleiter des Haushaltgeräts auf Grund von Nässe / Feuchtigkeit zu elektrischen Schlägen und im schlimmsten Fall zu Bränden im Gerät führen können.

Aus der DE 27 35 807 ist eine Geschirrspülmaschine bekannt, die eine Einrichtung zur Überwachung des Betriebsstroms aufweist. Hierzu ist ein Messwiderstand in einer Zuleitung der Geschirrspülmaschine angeordnet, der mit einem Analog-Digital-Wandler eines Mikroprozessors verbunden ist. Die ermittelten Messwerte werden mit abgespeicherten Werten verglichen, wobei auf eine Abweichung von einem Ist-Wert des aufgenommen Stromes das Steuergerät den weiteren Programmablauf beendet.

Aus der EP 0 838 192 A1 ist eine Elektroniksteuerung für einen Pumpenmotor einer Geschirrspülmaschine bekannt. Mit der Elektroniksteuerung kann überwacht werden, ob sich das Betriebsverhalten des Pumpenmotors durch Kalkablagerung an den Propellerblättern oder durch Belagbildung auf einem Filter verändert.

Aus der GB 2 283 870 A ist ein elektrisches Haushaltsgerät mit einer Fehleranzeige bekannt. Hierzu ist gemäß der GB 2 283 870 A vorgesehen, ein Leuchtmittel zwischen einem Nullleiter und einem Schutzleiter in Reihe mit einem Widerstand anzuordnen, so dass eine Spannungsdifferenz zwischen dem Nullleiter und dem Schutzleiter zu Anzeige gebracht werden kann. So können Fehlerströme erfassen werden, deren Stärke unterhalb der Auslöseschwelle einer elektrischen Sicherung liegt.

Der Erfindung liegt daher die Aufgabe zu Grunde, ein Verfahren und ein Haushaltgerät anzugeben, durch das sich auf möglichst einfache Art und Weise die elektrische Sicherheit des Haushaltgeräts besser überwachen lässt.

Diese Aufgabe wird hinsichtlich des Verfahrens durch die Merkmale des Patentanspruchs 1 und in Bezug auf das Haushaltgerät durch die Merkmale des Patentanspruchs 9 erfingdungsgemäß gelöst. Weiterbildungen der Erfindung sind in den Unteransprüchen angegeben.

Das Verfahren gemäß dem Gegenstand der Erfindung sieht vor, dass unmittelbar im Haushaltgerät wenigstens ein Stromsensor zur Messung der Fehlerstromaufnahme verwendet wird und dass abhängig von dem gemessenen oder ermittelten Stromwert eine Sicherheitsmaßnahme ausgelöst wird.

Das Haushaltgerät gemäß dem Gegenstand der Erfindung weist wenigstens einen unmittelbar im Haushaltgerät angeordneten Stromsensor zur Messung der Fehlerstromaufnahme und eine Steuereinrichtung zum Auslösen einer Sicherheitsmaßnahme abhängig von dem gemessenen oder ermittelten Stromwert auf.

Durch die erfindungsgemäße Anordnung eines Stromsensors unmittelbar im Haushaltgerät ist die zulässige Fehlerstromaufnahme direkt - quasi "vor Ort" - und geräteindividuell messbar, so dass die Sicherheitsmaßnahme abhängig von diesem Messwert - vorzugsweise nach Auswertung durch eine Steuereinrichtung des Haushaltgeräts - automatisch ausgelöst werden kann. Damit ergibt sich eine gegenüber Fehlerstromschutzschaltern, die gemäß üblicher Hausinstallationstechnik für den gesamten Haushalt nicht aber individuell auf die Geräte selbst optimiert sind, wesentlich verbesserte elektrische Sicherheit des Haushaltgeräts selbst. Sie hängt insbesondere nicht mehr von den Haus-Sicherungen ab, die individuelle geräteabhängige Erhöhungen des Stromverbrauchs - z.B. v.a. durch die wegen Brandgefahr besonders gefährlichen Kriechströme - nicht detektieren können, wie dies erst mit der Erfindung möglich ist. Mit der Erfindung ist ein Verfahren und ein Haushaltgerät geschaffen, durch das sich auf möglichst einfache Art und Weise die elektrische Sicherheit des Haushaltgeräts besser überwachen lässt.

Eine besonders günstige weil einfache, Aufwand sparende Variante der Erfindung sieht vor, dass durch den Stromsensor die Fehlerstromaufnahme auf dem Schutzleiter des Haushaltgeräts gemessen und mit einem vorgebbaren Referenz-Wert verglichen wird und dass bei Überschreiten des Referenz-Werts die Sicherheitsmaßnahme ausgelöst wird. Vorzugsweise ist der Stromsensor an einem Eingang des Stromnetzes angeordnet.

Eine Alternative zu obiger Lösung besteht gemäß einer Weiterbildung der Erfindung darin, dass durch den Stromsensor die Fehlerstromaufnahme auf einer Funkentstördoppeldrossel des Haushaltgeräts gemessen wird und dass bei einem Unterschied zumindest eines der beiden Ströme durch die beiden Spulen der Funkentstördoppeldrossel gegenüber einem Referenz-Wert die Sicherheitsmaßnahme ausgelöst wird. Nach einer weiteren bevorzugten Ausführungsform der Erfindung wirkt die Funkentstördoppeldrossel als Stromsensor für die Fehlerstromaufnahme, und werden die Ströme in beiden Spulen der Funkentstördoppeldrossel gemessen oder ermittelt und wird bei einem Unterschied zwischen beiden Strömen gegenüber einem Referenz-Unterschieds-Wert die Sicherheitsmaßnahme ausgelöst. Diese Varianten sind deshalb besonders günstig, weil durch die ohnehin vorhandene Funkentstördoppeldrossel - z.B. aus Gründen der Elektromechanischen Verträglichkeit (EMV) - kein Zusatzaufwand zur Messung der Fehlerstromaufnahme unmittelbar im Haushaltgerät notwendig ist und damit Kosten gespart werden.

Gemäß einer anderen vorteilhaften Variante der Erfindung wird im Haushaltgerät ein Fehlerstromschutzschalter nachgebildet und als Stromsensor verwendet. Damit lässt sich ein bewährtes Überwachungsmittel zur Erhöhung der elektrischen Sicherheit individuell auch im Haushaltgerät einsetzen.

Die bevorzugten Sicherheitsmaßnahmen gemäß alternativer Weiterbildungen der Erfindung bestehen darin, dass das Haushaltgerät abgeschaltet wird, dass eine oder mehrere elektrische Komponenten abgeschaltet werden oder dass ein akustisches und/oder ein optisches Warnsignal am Haushaltgerät ausgegeben wird.

Das Verfahren gemäß der Erfindung ist vorzugsweise für beliebige wasserführende Haushaltgeräte, besonders aber für Geschirrspülmaschinen vorteilhaft einsetzbar. Die Geschirrspülmaschine weist bekanntlich zur Aufnahme von Spülgut einen möglichst großzügig bemessenen Spülbehälter auf, der durch eine Gerätetür geöffnet und geschlossen werden kann. Eine Steuereinrichtung, die z.B. auch ein vom Benutzer der Geschirrspülmaschine ausgewählte oder ein automatisch ablaufendes Programm in seinem Ablauf steuert, kann die vom jeweiligen unmittelbar im Haushaltgerät angeordneten Stromsensor gemessene Fehlerstromaufnahme auswerten und die Sicherheitsmaßnahme abhängig von diesem Messwert auslösen. Bei Verwendung eines vorzugsweise an einem Eingang des Stromnetzes angeordneten Stromsensor, der die Fehlerstromaufnahme auf dem in der Geschirrspülmaschine vorhandenen Schutzleiter bestimmt, vergleicht die Steuereinrichtung den Messwert mit einem Referenz-Wert und löst die Sicherheitsmaßnahme dann aus, wenn der Referenz-Wert überschritten wird.

Anders verhält sich die Vorgehensweise, wenn zur Fehlerstromaufnahme die in der Geschirrspülmaschine bereits vorhandene Funkentstördoppeldrossel des Haushaltgeräts eingesetzt wird, wobei bei Ermittlung eines Unterschiedes zumindest eines der beiden Ströme durch die beiden Spulen der Funkentstördoppeldrossel gegenüber einem - ebenfalls voreinstellbaren Referenz-Wert die Sicherheitsmaßnahme ausgelöst wird. Überschreitet der tatsächlich aufgenommene Strom - erkennbar an dem durch die eine oder andere Spule gemessenen Stromwert - den erlaubten Referenz-Wert als Sicherheitswert - ggf. unter Berücksichtigung eines voreinstellbaren gegenüber der Normal-Fehlerstromaufnahme erhöhten Toleranzwertes -, kann die gesamte Geschirrspülmaschine oder einzelne elektrische Komponenten als Stromverbraucher automatisch abgeschaltet oder zumindest ein akustisches und/oder optisches Warnsignal an der oberhalb der Tür der Geschirrspülmaschine angeordneten Bedienblende ausgegeben werden.

Noch weiter wesentlich vereinfacht wird das Verfahren, wenn nach einer weiteren bevorzugten Ausführungsform der Erfindung die Funkentstördoppeldrossel selbst als Stromsensor für die Fehlerstromaufnahme wirkt. Dabei werden die Ströme in beiden Spulen der Funkentstördoppeldrossel gemessen oder ermittelt. Bei einem Unterschied zwischen beiden Strömen wird dieser Unterschied mit einem Referenz-Unterschieds-Wert verglichen und bei einem Unterschied gegenüber einem Referenz-Unterschieds-Wert werden die Sicherheitsmaßnahme ausgelöst.

Als weitere Variante eines Stromsensors gilt die Nachbildung eines aus der Hausinstallationstechnik an sich bekannten Fehlerstromschutzschalters, der aber zur geräteindividuellen Überwachung in die Geschirrspülmaschine eingebaut ist, um die Fehlerstromaufnahme als Stromsensor direkt vor Ort zu messen und an die Steuereinrichtung zur Auswertung für ein mögliches Auslösen einer der Sicherheitsmaßnahmen zu übertragen.

Mit der Erfindung ist ein Verfahren und ein Haushaltgerät geschaffen, durch das sich auf möglichst einfache Art und Weise die elektrische Sicherheit des Haushaltgeräts besser überwachen lässt.

## Patentansprüche

1. Verfahren zur Überprüfung der elektrischen Sicherheit eines Haushaltgeräts, das mehrere elektrische Komponenten als Stromverbraucher aufweist,
**dadurch gekennzeichnet,**
**dass** unmittelbar im Haushaltgerät wenigstens ein Stromsensor zur Messung der Fehlerstromaufnahme verwendet wird und dass abhängig von dem gemessenen oder ermittelten Stromwert eine Sicherheitsmaßnahme ausgelöst wird.

2. Verfahren nach Anspruch 1, **dadurch gekennzeichnet, dass** durch den wenigstens einen Stromsensor die Fehlerstromaufnahme auf dem Schutzleiter des Haushaltgeräts gemessen und mit einem vorgebbaren Referenz-Wert verglichen wird und dass bei Überschreiten des Referenz-Werts die Sicherheitsmaßnahme ausgelöst wird.

3. Verfahren nach Anspruch 2, **dadurch gekennzeichnet, dass** der Stromsensor zur Messung der Fehlerstromaufnahme auf dem Schutzleiter an einem Eingang des Stromnetzes angeordnet ist.

4. Verfahren nach Anspruch 1, **dadurch gekennzeichnet, dass** durch den Stromsensor die Fehlerstromaufnahme auf einer Funkentstördoppeldrossel des Haushaltgeräts gemessen wird und dass bei einem Unterschied zumindest einem der beiden Ströme durch die beiden Spulen der Funkentstördoppeldrossel gegenüber einem Referenz-Wert die Sicherheitsmaßnahme ausgelöst wird.

5. Verfahren nach Anspruch 1, **dadurch gekennzeichnet, dass** die Funkentstördoppeldrossel als Stromsensor für die Fehlerstromaufnahme wirkt, dass die Ströme in beiden Spulen der Funkentstördoppeldrossel gemessen oder ermittelt werden und dass bei einem Unterschied zwischen beiden Strömen gegenüber einem Referenz-Unterschieds-Wert die Sicherheitsmaßnahme ausgelöst wird.

6. Verfahren nach Anspruch 1, **dadurch gekennzeichnet, dass** im Haushaltgerät ein Fehlerstromschutzschalter nachgebildet und als Stromsensor verwendet wird.

7. Verfahren nach einem der Ansprüche 1 bis 6, **dadurch gekennzeichnet, dass** als Sicherheitsmaßnahme eine oder mehrere elektrische Komponenten abgeschaltet werden.

8. Verfahren nach einem der Ansprüche 1 bis 6, **dadurch gekennzeichnet, dass** als Sicherheitsmaßnahme ein akustisches und/oder ein optisches Warnsignal am Haushaltgerät ausgegeben wird.

9. Verfahren nach einem der vorhergehenden Ansprüche, **dadurch gekennzeichnet, dass** das Haushaltgerät ein wasserführendes Haushaltgerät ist.

10. Verfahren nach einem der vorhergehenden Ansprüche, **dadurch gekennzeichnet, dass** das Haushaltgerät eine Geschirrspülmaschine ist.

11. Haushaltgerät zur Durchführung des Verfahrens nach einem der vorhergehenden Ansprüche, **gekennzeichnet durch** wenigstens einen unmittelbar im Haushaltgerät angeordneten Stromsensor zur Messung der Fehlerstromaufnahme und eine Steuereinrichtung zum Auslösen einer Sicherheitsmaßnahme abhängig von dem gemessenen oder ermittelten Stromwert.

## Claims

1. Method for checking the electrical safety of a domestic appliance which has several electrical components as current consumers, **characterised in that** at least one current sensor for measurement of the fault current draw is used directly in the domestic appliance and that a safety measure is triggered depending on the measured or detected current value.

2. Method according to claim 1, **characterised in that** the fault current take-up on the first conductor of the domestic appliance is measured by the at least one current sensor and compared with a predeterminable reference value and that the safety measure is triggered if the reference value is exceeded.

3. Method according to claim 2, **characterised in that** the current sensor for measuring the fault current draw is arranged on the earth conductor at an input of the power mains.

4. Method according to claim 1, **characterised in that** the fault current draw on a radio interference suppression choke of the domestic appliance is measured by the current sensor and that the safety measure is triggered if there is a difference between one of the two currents through the two coils of the radio interference suppression choke by comparison with a reference value.

5. Method according to claim 1, **characterised in that** the radio interference suppression choke acts as current sensor for the fault current draw, that the currents in the two coils of the radio interference suppression choke are measured or detected and that the safety measure is triggered if there is a difference between the two currents by comparison with a reference difference value.

6. Method according to claim 1, **characterised in that** a fault current circuitbreaker is simulated in the domestic appliance and used as current sensor.

7. Method according to any one of claims 1 to 6, **characterised in that** one or more electrical components are switched off as safety measure.

8. Method according to any one of claims 1 to 6, **characterised in that** an acoustic and/or optical warning signal is issued at the domestic appliance as safety measure.

9. Method according to any one of the preceding claims, **characterised in that** the domestic appliance is a water-conducting domestic appliance.

10. Method according to any one of the preceding claims, **characterised in that** the domestic appliance is a dishwashing machine.

11. Domestic appliance for performance of the method according to any one of the preceding claims, **characterised by** at least one current sensor, which is arranged directly in the domestic appliance, for measuring the fault current draw and a control device for triggering a safety measure depending on the measured or determined current value.

## Revendications

1. Procédé de vérification de la sécurité électrique d'un appareil ménager qui présente plusieurs composants électriques en tant que consommateurs de courant,
**caractérisé en ce**
**qu'**au moins un capteur de courant destiné à la mesure du courant de fuite absorbé est utilisé directement dans l'appareil ménager et en ce qu'une mesure de sécurité est déclenchée en fonction de la valeur du courant mesurée ou déterminée.

2. Procédé selon la revendication 1, **caractérisé en ce que** le courant de fuite absorbé est mesuré sur le conducteur de protection de l'appareil ménager au moyen de l'au moins un capteur de courant et comparé à une valeur de référence pouvant être prédéfinie, et **en ce que** la mesure de sécurité est déclenchée lorsque la valeur de référence est dépassée.

3. Procédé selon la revendication 2, **caractérisé en ce que** le capteur de courant destiné à la mesure du courant de fuite absorbé est disposé sur le conducteur de protection sur une entrée du réseau de courant.

4. Procédé selon la revendication 1, **caractérisé en ce que** le courant de fuite absorbé est mesuré sur une bobine de réactance double d'antiparasitage de l'appareil ménager au moyen du capteur de courant et **en ce que** la mesure de sécurité est déclenchée lors d'une différence au moins de l'un des deux courants à travers les deux bobines de la bobine de réactance double d'antiparasitage par rapport à une valeur de référence.

5. Procédé selon la revendication 1, **caractérisé en ce que** la bobine de réactance double d'antiparasitage agit en tant que capteur de courant pour le courant de fuite absorbé, **en ce que** les courants sont mesurés ou déterminés dans les deux bobines de la bobine de réactance double d'antiparasitage et **en ce que** la mesure de sécurité est déclenchée lors d'une différence entre les deux courants par rapport à une valeur de différence de référence.

6. Procédé selon la revendication 1, **caractérisé en ce qu'**un disjoncteur de protection de courant de fuite est reproduit dans l'appareil ménager et utilisé en tant que capteur de courant.

7. Procédé selon l'une quelconque des revendications 1 à 6, **caractérisé en ce qu'**un ou plusieurs composants électriques sont mis hors circuit en tant que mesure de sécurité.

8. Procédé selon l'une quelconque des revendications 1 à 6, **caractérisé en ce qu'**un signal d'avertissement acoustique et/ou visuel est sorti sur l'appareil ménager en tant que mesure de sécurité.

9. Procédé selon l'une quelconque des revendications précédentes, **caractérisé en ce que** l'appareil ménager est un appareil ménager conduisant de l'eau.

10. Procédé selon l'une quelconque des revendications précédentes, **caractérisé en ce que** l'appareil ménager est un lave-vaisselle.

11. Appareil ménager pour la réalisation du procédé selon l'une quelconque des revendications précédentes, **caractérisé par** au moins un capteur de courant disposé directement dans l'appareil ménager, destiné à la mesure du courant de fuite absorbé et par un dispositif de commande destiné à déclencher une mesure de sécurité en fonction de la valeur du courant mesurée ou déterminée.
